# EUROPÄISCHE PATENTANMELDUNG

(11) **EP 4 274 044 A1**
(43) Veröffentlichungstag der Anmeldung: **08.11.2023**
(21) Anmeldenummer: 22171176.5
(22) Anmeldetag: 02.05.2022
(51) Int. Cl.: H02G 11/00, A47B 88/447, F16C 33/40

(54) **LINEARES FÜHRUNGSSYSTEM**

(71) Anmelder: Accuride International GmbH, 65582 Diez/Lahn (DE)
(72) Erfinder: SATONY, Christian, 56182 Urbar (DE); NEUHAUS, Christoph, 56412 Niederelbert (DE); QUIREIN, Thomas, 65582 Diez (DE); TREMOLIERES, Laurent, 65550 Limburg-Linter (DE)
(74) Vertreter: WSL Patentanwälte Partnerschaft mbB

(57) **Zusammenfassung**

Die vorliegende Erfindung betrifft ein lineares Führungssystem mit einem ersten Schienenelement, einem zweiten Schienenelement und einem dritten Element, wobei das erste Schienenelement und das zweite Schienenelement derart gelagert sind, dass das erste Schienenelement und das zweite Schienenelement in und entgegen einer Auszugsrichtung linear gegeneinander verschiebbar sind, und wobei das dritte Element und das erste Schienenelement sowie das dritte Element und das zweite Schienenelement aneinander gelagert sind, so dass das dritte Element und das erste Schienenelement sowie das dritte Element und das zweite Schienenelement in und entgegen der Auszugsrichtung linear gegeneinander verschiebbar sind. Dabei weist das lineare Führungssystem zudem einen elektrischen Leiter auf, wobei der elektrische Leiter an dem ersten Schienenelement an einem ersten Festlegungsort und an dem zweiten Schienenelement an einem ersten Festlegungsort festgelegt ist, wobei der elektrische Leiter gegenüber zumindest dem dritten Element elektrisch isoliert ist und wobei der elektrische Leiter an einem Umlenkort an dem dritten Element umgelenkt ist.

## Beschreibung

Die vorliegende Erfindung betrifft ein lineares Führungssystem mit einem ersten Schienenelement, einem zweiten Schienenelement und einem dritten Element, wobei das erste Schienenelement und das zweite Schienenelement derart gelagert sind, dass das erste Schienenelement und das zweite Schienenelement in und entgegen einer Auszugsrichtung linear gegeneinander verschiebbar sind, wobei das dritte Element und das erste Schienenelement sowie das dritte Element und das zweite Schienenelement aneinandergelagert sind, sodass das dritte Element und das erste Schienenelement sowie das dritte Element und das zweite Schienenelement in und entgegen der Auszugsrichtung linear gegeneinander verschiebbar sind.

Solche linearen Führungssysteme, insbesondere in Form von Auszugsschienen und Linearführungen, sind in mannigfaltigen Ausführungsformen aus dem Stand der Technik bekannt. Sie werden in verschiedenen Haushaltsgeräten, aber auch im Automobilbau und in vielen weiteren Anwendungen eingesetzt. In einer Vielzahl von Anwendungsbereichen kommen bereits lineare Führungssysteme zum Einsatz, die motorisch angetrieben sind. Mit dem Wunsch nach einem motorischen Antrieb geht häufig einher, dass an dem mithilfe des linearen Führungssystems gegenüber einem stationären Element bewegten Element ein elektrischer Verbraucher oder auch eine Datennetzwerkkomponente vorgesehen sein soll. Ein Beispiel für einen elektrischen Verbraucher ist eine Beleuchtung oder eine Steckdose. Ein Beispiel für eine Datennetzwerkkomponente ist eine LAN-Dose oder ein Router. Darüber hinaus führen aktuelle Entwicklungen, wie z.B. Industrie 4.0 und auch IoT (Internet of Things), völlig unabhängig von einem motorischen Antrieb der Schiene dazu, dass in immer mehr Anwendungen mit linear gegeneinander verschiebbaren Elementen Teile mit Strom und Daten versorgt werden müssen. Hierfür müssen entsprechende Leitungen bereitgestellt werden.

Da das stationäre Element und das bewegte Element mittels des linearen Führungssystems eine Relativbewegung zueinander ausführen und eine Vielzahl von Zwischenpositionen zwischen zwei Endpositionen einnehmen können, setzt eine elektrische Leistungsversorgung oder eine kabelgebundene Datenanbindung an dem bewegten Element einen mit dem bewegten Element mitbewegbaren elektrischen Leiter voraus. Als Beispiel kann ein Schubladenauszug dienen, wobei in der Schublade eine Brotschneidemaschine als elektrischer Verbraucher angeordnet ist. Im Stand der Technik wird dann ein Kabel mit einer Überlänge lose zwischen dem Stationären Element, beispielsweise dem Schrankkorpus, und dem bewegten Element verlegt. Dies birgt das Risiko, dass das Kabel mit dem elektrischen Leiter während des Gebrauchs des linearen Führungssystems in irgendeiner Weise in das Führungssystem eingreift und dadurch Beschädigungen entweder am Kabel oder am Führungssystem oder an beiden hervorgerufen werden. Daher gibt es im Stand der Technik Kabelträger und Energieketten, welche die Gefahr der Beschädigung des Kabels reduzieren, da sie das Kabel in einem geschützten Gehäuse führen. Allerdings weisen Kabelträger und Energieketten vergleichsweise große Abmessungen auf und reduzieren somit den zur Verfügung stehenden Einbauraum.

Demgegenüber ist es Aufgabe der vorliegenden Erfindung, ein lineares Führungssystem bereitzustellen, das eine elektrische Leistungs- oder Signalübertragung von einem feststehenden Element zu einem demgegenüber linear bewegbaren Element ermöglicht und die Nachteile aus dem Stand der Technik vermeidet.

Erfindungsgemäß wird diese Aufgabe durch ein lineares Führungssystem gemäß dem unabhängigen Anspruch 1 gelöst. Dazu weist das lineare Führungssystem der eingangs genannten Art einen elektrischen Leiter auf, wobei der elektrische Leiter an dem ersten Schienenelement an einem ersten Festlegungsort und an dem zweiten Schienenelement an einem zweiten Festlegungsort festgelegt ist, wobei der elektrische Leiter gegenüber zumindest dem dritten Element elektrisch isoliert ist und wobei der elektrische Leiter an einem Umlenkort an dem dritten Element umgelenkt ist.

Der vorliegenden Erfindung liegt die Idee zugrunde, ein lineares Führungssystem mit mindestens zwei gegeneinander linear verschiebbar gelagerten Schienenelementen bereitzustellen, wobei der elektrische Leiter für eine elektrische Leistungs- oder Signalübertragung an dem ersten Schienenelement und dem zweiten Schienenelement jeweils festgelegt ist und an einem dritten Element, welches linear gegenüber dem ersten und dem zweiten Schienenelement verschiebbar gelagert ist, umgelenkt wird.

Die erfindungsgemäße Anordnung ermöglicht es, den elektrischen Leiter im Innenraum zwischen den ersten und zweiten Schienenelementen bzw. zwischen dem ersten Schienenelement oder dem zweiten Schienenelement und dem dritten Element geschützt aufzunehmen. Dabei sorgt das dritte Element für die erforderliche Führung bzw. Spannung des elektrischen Leiters, sodass dieser nicht mit den Schienenelementen oder dem dritten Element in Eingriff kommt und es zu keiner Beschädigung der Schienenelemente, des dritten Elements oder des elektrischen Leiters kommt.

Die Erfindung ermöglicht es, in Anwendungen eine elektrische Anbindung über ein lineares Führungssystem bereitzustellen, die zuvor aufwendig mit sperrigen Kabelträgern oder Energieketten ausgestattet werden mussten. Beispiele dafür sind ein in einen Schubladengriff integrierter Fingerabdrucksensor, der die Schublade dem Benutzer beim Greifen des Griffs freigibt, und ein Lidar-Sensor an einem Auszugssystem zum Detektieren von Gegenständen im Verfahrweg.

Die Leistungs- und/oder Signalübertragung erfolgt in einer Ausführungsform ausschließlich über den elektrischen Leiter und die ersten und zweiten Schienenelemente sowie das dritte Element dienen lediglich der mechanischen Führung des elektrischen Leiters.

In einer Ausführungsform der Erfindung ist der elektrische Leiter zumindest auch gegenüber dem ersten Schienenelement oder dem zweiten Schienenelement, vorzugsweise jedoch gegenüber dem ersten Schienenelement und dem zweiten Schienenelement, elektrisch isoliert.

Unter einem elektrischen Leiter im Sinne der vorliegenden Erfindung wird ein elektrisch leitendendes Element, insbesondere ein Draht, eine Faser, ein Filament oder eine Folie, verstanden. Es versteht sich, dass ein solcher elektrischer Leiter aus einem elektrisch leitfähigen Material hergestellt ist. Geeignet ist dafür insbesondere Metall, aber auch elektrisch leitende nichtmetallische Materialien wie Graphit kommen in Betracht. Letztere weisen häufig den Vorteil einer guten Integrierbarkeit auf. So kann beispielsweise Graphit in Form einer Faser in ein Band eingewebt werden.

In einer Ausführungsform der Erfindung ist der elektrische Leiter Bestandteil eines elektrischen Kabels mit einer Isolierung und dem elektrischen Leiter oder einer Mehrzahl von elektrischen Leitern. In einer Ausführungsform der Erfindung ist der elektrische Leiter Bestandteil eines Flachbandkabels. Flachbandkabel weisen den Vorteil auf, dass bei entsprechender Führung und Umlenkung der Umlenkradius für alle elektrischen Leiter im Inneren des Flachbandkabels in etwa gleich groß ist. In einer Ausführungsform der Erfindung umfasst das lineare Führungssystem eine Mehrzahl von elektrischen Leitern. Dabei kann die Mehrzahl von elektrischen Leitern in einem einzigen Kabel zusammengefasst sein.

Ist der elektrische Leiter Bestandteil eines Flachbandkabels, so kann das Flachbandkabel entweder parallel oder senkrecht zu einem Schienenrücken des ersten oder des zweiten Schienenelements orientiert sein.

Wenn in der vorliegenden Anmeldung beschrieben wird, dass der elektrische Leiter in Kontakt mit einem weiteren Element, insbesondere in Kontakt mit dem dritten Element bzw. einem Umlenkelement des dritten Elements ist, so ist davon auch ein mittelbarer Kontakt umfasst, bei dem die Isolierung eines Kabels, welche den elektrischen Leiter umgibt, in Kontakt mit dem weiteren Element ist.

Der elektrische Leiter stellt insbesondere eine elektrisch leitende Verbindung zwischen dem feststehenden Schienenelement und dem beweglichen Schienenelement dar.

Die erfindungsgemäße Umlenkung ist insbesondere dann vorteilhaft, wenn der elektrische Leiter an dem Umlenkort des dritten Elements derart umgelenkt ist, dass unabhängig von einer Auszugsposition des ersten Schienenelements gegenüber dem zweiten Schienenelement eine Gesamtweglänge des elektrischen Leiters im Wesentlichen konstant ist. Dabei wird unter der Gesamtweglänge des elektrischen Leiters nicht dessen Länge als solche betrachtet (diese wäre konstant unabhängig davon, wie der elektrische Leiter in dem linearen Führungssystem geführt und umgelenkt ist), sondern die Länge des Weges, über welchen der elektrische Leiter in dem linearen Führungssystem geführt ist. Die Gesamtweglänge des elektrischen Leiters im Sinne der vorliegenden Anmeldung ist gebildet aus einer ersten Teilweglänge zwischen dem ersten Festlegungsort an dem ersten Schienenelement und dem Umlenkort an dem dritten Element und aus einer zweiten Weglänge zwischen dem zweiten Festlegungsort an dem zweiten Schienenelement und dem Umlenkort an dem dritten Element.

Die Konstanz dieser Gesamtweglänge des elektrischen Leiters unabhängig von der Auszugsposition des ersten Schienenelements gegenüber dem zweiten Schienenelement ist insbesondere dann gewährleistet, wenn das dritte Element und das erste Schienenelement sowie das dritte Element und das zweite Schienenelement derart linear gegeneinander verschiebbar sind, dass eine Verschiebung des ersten Schienenelements gegenüber dem zweiten Schienenelement um einen ersten Verschiebeweg zu einer Verschiebung des dritten Elements gegenüber dem ersten Schienenelement um einen zweiten Verschiebeweg führt, wobei der zweite Verschiebeweg gleich der Hälfte des ersten Verschiebewegs ist.

Für das dritte Element im Sinne der vorliegenden Anmeldung gibt es mehrere Realisierungsmöglichkeiten.

In einer Ausführungsform der Erfindung ist das dritte Element ein Wälzkörperkäfig, der zwischen dem ersten Schienenelement und dem zweiten Schienenelement angeordnet ist, wobei an dem Wälzkörperkäfig eine Mehrzahl von Wälzkörpern aufgenommen ist, und wobei jeder aus der Mehrzahl von Wälzkörpern auf einer Lauffläche des ersten Schienenelements und auf einer Lauffläche des zweiten Schienenelements abrollt. Man kann auch sagen, dass jeder aus der Mehrzahl von Wälzkörpern zwischen einer Lauffläche des ersten Schienenelements und einer Lauffläche des zweiten Schienenelements wälzt. Ein derartiger Wälzkörperkäfig zwischen dem ersten Schienenelement und dem zweiten Schienenelement bewegt sich aufgrund der Wälzbewegung der daran aufgenommenen Wälzkörper zwischen den Laufflächen der beiden Schienenelemente, wenn das erste Schienenelement gegenüber dem zweiten Schienenelement um eine erste Verschiebestrecke bewegt wird, um eine zweite Verschiebestrecke gegenüber dem ersten Schienenelement. Die zweite Verschiebestrecke beträgt dann etwas die Hälfte der ersten Verschiebestrecke. Auf diese Weise wird der an dem Wälzkörperkäfig umgelenkte elektrische Leiter immer mit einer konstanten Gesamtweglänge geführt.

Eine solche Ausführungsform des linearen Führungssystems, in dem das dritte Element ein Wälzkörperkäfig ist, eignet sich insbesondere für eine Auszugsschiene, die einen Teilauszug mit nur zwei Schienenelementen bildet, oder für eine Linearführung mit nur zwei Schienenelementen.

Jedoch lässt sich mit einer solchen Variante auch eine Auszugschiene, die einen Voll- oder Überauszug bildet, realisieren. Dann ist zwischen dem ersten und dem zweiten Schienenelement ein drittes Schienenelement vorgesehen. Das dritte Schienenelement wird auch als Mittenschiene (sie ist zwischen dem ersten und dem zweiten Schienenelement angeordnet) bezeichnet.

Die Lagerung des ersten Schienenelements an dem dritten Schienenelement erfolgt über eine Mehrzahl von in einem ersten Wälzkörperkäfig angeordneten Wälzkörpern und die Lagerung des zweiten Schienenelements an dem dritten Schienenelement erfolgt ebenfalls über eine Mehrzahl von an einem zweiten Wälzkörperkäfig aufgenommenen Wälzkörpern. Die ersten und zweiten Wälzkörperkäfige lenken dann jeweils einen elektrischen Leiter um. Der erste elektrische Leiter ist an dem ersten Schienenelement und dem dritten Schienenelement festgelegt und wird von dem ersten Wälzkörperkäfig umgelenkt. Der zweite elektrische Leiter ist an dem dritten Schienenelement und dem zweiten Schienenelement festgelegt und wird von dem zweiten Wälzkörperkäfig umgelenkt. Der erste und der zweite Wälzkörperkäfig bilden auch in einer solchen Ausführungsform das dritte Element mit der Umlenkung des elektrischen Leiters im Sinne der vorliegenden Anmeldung.

In einer Ausführungsform der Erfindung ist das lineare Führungssystem eine Auszugsschiene und das dritte Element, welches der Umlenkung des elektrischen Leiters dient, ist ein drittes Schienenelement. Das erste Schienenelement ist dann verschiebbar an dem dritten Schienenelement gelagert ebenso wie das zweite Schienenelement verschiebbar an dem dritten Schienenelement gelagert ist. Eine solche Ausführungsform ermöglicht insbesondere die Ausgestaltung eines Vollauszugs oder eines Überauszugs.

Grundsätzlich ist es möglich, eine erfindungsgemäße Auszugsschiene mit den ersten, zweiten und dritten Schienenelementen zu realisieren, wobei jeweils zwei Schienenelemente eine Gleitführung aneinander bilden, solange die Bewegung der drei Schienenelemente synchronisiert zueinander erfolgt. Eine derartige Synchronisierung der Auszugsbewegung der Schienenelemente kann wie weiter unten im Detail ausgeführt durch ein zusätzliches Zugorgan, welches an dem ersten und dem zweiten Schienenelement festgelegt und an einem ersten und einem zweiten Ende des dritten Schienenelements umgelenkt ist, bewirkt werden. Alternativ lässt sich die Synchronisierung durch den an dem ersten und dem zweiten Schienenelement festgelegten und an einem ersten Ende des dritten Schienenelements umgelenkten elektrischen Leiter bzw. das Kabel sowie zusätzlich ein an dem ersten und dem zweiten Schienenelement festgelegtes und an dem zweiten Ende des dritten Schienenelements umgelenktes Zugorgan bewirken.

Jedoch sind in einer Ausführungsform die ersten, zweiten und dritten Schienenelemente der Auszugsschiene paarweise mit jeweils einer Wälzkörperlagerung aneinander geführt. Unabhängig davon, dass die ersten, zweiten und dritten Schienenelemente über eine Wälzkörperlagerung miteinander verbunden sind, dienen in einer solchen Ausführungsform aber nicht die Wälzkörperkäfige der Umlenkung des elektrischen Leiters, sondern das dritte Schienenelement als drittes Element im Sinne der vorliegenden Anmeldung. Es versteht sich, dass auch in einer solchen Ausführungsform die zuvor skizzierte Synchronisierung umgesetzt sein muss.

Auch ist es möglich ein Wälzkörperlager zwischen einem ersten Paar von Schienenelementen und ein Gleitlager zwischen einem zweiten Paar von Schienenelementen der gleichen Auszugsschiene vorzusehen.

In einer Ausführungsform der Erfindung weist das dritte Element, unabhängig davon, ob das dritte Element von einem Kugelkäfig oder einem dritten Schienenelement gebildet wird, an dem Umlenkort ein Umlenkelement auf. Der elektrische Leiter ist mit dem Umlenkelement in Kontakt und wird von dem Umlenkelement umgelenkt. Dabei erfolgt die Umlenkung an dem dritten Element bzw. an dem Umlenkelement des dritten Elements so, dass der elektrische Leiter nach der Umlenkung an dem Umlenkelement im Wesentlichen parallel zur Auszugsrichtung verläuft, wobei die Umlenkung den elektrischen Leiter um etwa 180° umlenkt.

In einer Ausführungsform der Erfindung ist das Umlenkelement ausgewählt aus einer Gruppe, die eine konvex gekrümmte Gleitfläche, eine Mehrzahl von in einer Umfangsrichtung angeordneten Gleitflächenabschnitten mit zumindest einer Ausnehmung zwischen zwei Gleitflächenabschnitten und eine schwenkbare Umlenkrolle oder eine Kombination davon umfasst.

Bei der Umlenkung ist zu berücksichtigen, dass diese dynamisch erfolgt. Der mit dem Umlenkelement in Kontakt befindliche Abschnitt des elektrischen Leiters bzw. der den elektrischen Leiter umgebenden Isolierung (der Kontakt zwischen dem elektrischen Leiter und dem Umlenkelement ist dann mittelbar) ändert sich fortwährend während einer Auszugs- oder Einschubbewegung. Daher muss entweder das Umlenkelement schwenk- oder drehbar gelagert sein oder aber ein Gleiten des elektrischen Leiters bzw. seiner Isolierung gegenüber dem Umlenkelement ermöglichen.

Aufgrund der beschriebenen Dynamik der Umlenkung, aber auch, um eine einfachere Montage zu ermöglichen, weist in einer Ausführungsform der Erfindung das dritte Element ein Umlenkelement auf, wobei das Umlenkelement gegenüber einem Grundkörper des dritten Elements zumindest an einer ersten Spannposition und an einer zweiten Spannposition in der Auszugsrichtung positionierbar ist. Eine solche Variante ermöglicht es, den elektrischen Leiter und gegebenenfalls mit ihm seine Isolierung zu straffen oder zu spannen.

Dabei kann die Positionierbarkeit des Umlenkelements gegenüber dem Grundkörper des dritten Elements so ausgestaltet sein, dass diese diskret ist. D.h. bei der Montage wird einmal die Position des Umlenkelements gegenüber dem Grundkörper auswählbar festgelegt. Ob das Umlenkelement relativ zu dem Grundkörper in der ersten Spannposition oder der zweiten Spannposition angeordnet wird, hängt in einer solchen Ausführungsform beispielsweise von der konkret montierten Kabellänge oder anderen Herstellungstoleranzen ab.

Eine diskrete Straffung oder Spannung des elektrischen Leiters bzw. des Kabels lässt sich aber auch derart realisieren, dass der erste Festlegungsort an dem ersten Schienenelement oder der zweite Festlegungsort an dem zweiten Schienenelement an diskreten Positionen des jeweiligen Schienenelements auswählbar ist.

In einer Ausführungsform der Erfindung ist jedoch das Umlenkelement in der Auszugsrichtung federnd vorgespannt bzw. an dem Grundkörper des dritten Elements federnd abgestützt, sodass das Umlenkelement den elektrischen Leiter federnd spannt. Es versteht sich, dass auch in einer solchen Ausführungsform, in Abhängigkeit von der Länge des elektrischen Leiters bzw. des Kabels, das Umlenkelement gegenüber dem Grundkörper an mindestens zwei Spannpositionen, insbesondere aber über einen kontinuierlichen Spannweg, positionierbar ist.

Eine derartige Federvorspannung des Umlenkelements gegenüber dem Grundkörper des dritten Elements lässt sich beispielsweise dadurch realisieren, dass zwischen dem Umlenkelement und dem Grundkörper eine Feder, beispielsweise eine Spiralfeder, vorgesehen ist, welcher das Umlenkelement in oder entgegen der Auszugsrichtung vorspannt.

Ein federnd vorgespanntes Umlenkelement lässt sich jedoch auch einstückig mit dem Grundkörper ausgestalten. Ist das dritte Element beispielsweise ein Wälzkörperkäfig, so kann das Umlenkelement als Lasche aus einem Blech des Wälzkörperkäfigs ausgestanzt und zu dem Umlenkelement mit einer konvex gekrümmten Gleitfläche umgebogen sein. Ein solches gekrümmtes Umlenkelement aus Blech kann per se federnd ausgestaltet sein, sodass seine Gleitfläche den elektrischen Leiter spannt. Alternativ kann der Wälzkörperkäfig einstückig aus Kunststoff, beispielswiese durch Spritzgießen, hergestellt sein.

In einer Ausführungsform der Erfindung kann ein Kabelspanner jedoch auch an dem ersten Schienenelement oder an dem zweiten Schienenelement oder an dem dritten Element vorgesehen sein, wobei der Kabelspanner den elektrischen Leiter bzw. das Kabel in einer Richtung senkrecht zur Auszugsrichtung federnd spannt.

In einer alternativen Ausführungsform ist es möglich, den ersten Festlegungsort an dem ersten Schienenelement oder den zweiten Festlegungsort an dem zweiten Schienenelement in der Auszugsrichtung federnd vorgespannt anzuordnen. Auch auf diese Weise kann eine Spannung des elektrischen Leiters bzw. des Kabels erreicht werden.

In einer Ausführungsform der Erfindung erfolgt eine exakte Konfektionierung der Länge des elektrischen Leiters relativ zur Gesamtweglänge des elektrischen Leiters so, dass der elektrische Leiter nach der Montage nur ein vertretbares Spiel gegenüber dem Umlenkelement aufweist.

In einer Ausführungsform der Erfindung weist das lineare Führungssystem ein elektrisches Verbindungselement auf, wobei ein erstes Ende des elektrischen Leiters mit dem Verbindungselement konfektioniert es. Ein Beispiel für ein solches elektrisches Verbindungselement ist ein Stecker oder eine Buchse zum Kontaktieren des elektrischen Leiters mit einem dazu komplementären Verbindungselement.

In einer Ausführungsform der Erfindung ist das Verbindungselement an dem ersten oder zweiten Schienenelement befestigt. Eine solche Befestigung des Verbindungselements an dem ersten oder zweiten Schienenelement ermöglicht die Bereitstellung eines "Plug-and-Play"-Systems. Der Nutzer des linearen Führungssystems montiert dieses mechanisch und kontaktiert die Verbindungselemente elektrisch.

Zur Befestigung des elektrischen Verbindungselements an dem jeweiligen Schienenelement gibt es eine Vielzahl von Möglichkeiten. In einer Ausführungsform der Erfindung ist das Verbindungselement stoffschlüssig, beispielsweise durch Kleben oder Schweißen, oder formschlüssig mit dem jeweiligen Schienenelement verbunden. Für einen Formschluss geeignet ist insbesondere eine Ausführungsform des elektrischen Verbindungselements, welches eine oder mehrere Rastnasen aufweist, wobei das Verbindungselement in eine Durchbrechung in dem jeweiligen Schienenelement, vorzugsweise im Schienenrücken des Schienenelements, eingeführt und mithilfe der Rastnasen verrastet ist. In einer Ausführungsform der Erfindung weist das Verbindungselement eine Ausnehmung in Form einer Vertiefung oder einer Durchbrechung auf, wobei das Verbindungselement auf eine aus dem Schienenelement, vorzugsweise aus dem Schienenrücken des Schienenelements, ausgestanzten und abgebogenen Lasche aufgesteckt ist.

Es versteht sich, dass in einer Ausführungsform der Erfindung jedes Ende des elektrischen Leiters mit jeweils mindestens einem Verbindungselement konfektioniert ist. Dabei ist das Verbindungselement an dem ersten Ende des elektrischen Leiters an dem ersten Schienenelement befestigt und das Verbindungselement an dem zweiten Ende des elektrischen Leiters ist an dem zweiten Schienenelement befestigt.

In einer Ausführungsform ist das Verbindungselement derart ausgestaltet, dass es den elektrischen Leiter an dem ersten Schienenelement oder dem zweiten Schienenelement festlegt. In einer solchen Ausführungsform ist das Verbindungselement nicht nur an dem Schienenelement montiert, sondern es dient auch der Festlegung des elektrischen Leiters an dem Schienenelement. Das Verbindungelement dient dann auch der Einleitung von auf den elektrischen Leiter wirkenden Zugkräften in das jeweilige Schienenelement.

Ein an dem dritten Schienenelement umgelenkter elektrischer Leiter führt auch zu einer Synchronisierung der Auszugsbewegung des zweiten Schienenelements gegenüber dem dritten Schienenelement, wenn das dritte Schienenelement gegenüber dem ersten Schienenelement relativ bewegt wird.

In einer Ausführungsform der Erfindung ist das lineare Führungssystem eine Auszugsschiene, wobei das dritte Element ein drittes Schienenelement ist. In einer solchen Ausführungsform kann es zweckmäßig sein, wenn das dritte Schienenelement an dem Umlenkort ein Umlenkelement aufweist, wobei der elektrische Leiter mit dem Umlenkelement in Kontakt ist und von dem Umlenkelement umgelenkt wird, wobei die Auszugsschiene ein Zugorgan aufweist, wobei das Zugorgan an dem ersten Schienenelement und an dem dritten Schienenelement festgelegt ist und wobei das Zugorgan an dem Umlenkelement in einer Richtung parallel zu der Auszugsrichtung derart geführt ist, dass eine Verschiebebewegung des dritten Schienenelements gegenüber dem ersten Schienenelement zu einer Verschiebebewegung des zweiten Schienenelements gegenüber dem dritten Schienenelement führt.

Daher ist in einer Ausführungsform der Erfindung der elektrische Leiter in ein, vorzugsweise bandförmiges, Zugorgan integriert. In einer Ausführungsform ist der elektrische Leiter in das Zugorgan eingewoben. Ein solches Zugorgan, beispielsweise aus einem Kunststoffmaterial, weist eine hohe Zugfestigkeit auf und kann daher die erforderliche Festigkeit für eine Synchronisationsfunktion bereitstellen, welche der elektrische Leiter möglicherweise alleine nicht gewährleisten könnte.

In einer dazu alternativen Ausführungsform sind das Zugorgan und der elektrische Leiter, insbesondere der elektrische Leiter in einem Kabel, als getrennte Elemente ausgeführt. In einer solchen Ausführungsform ist es zweckmäßig, wenn das Umlenkelement eine erste Umlenkfläche und eine zweite Umlenkfläche aufweist, wobei die erste Umlenkfläche mit dem Zugorgan in Kontakt ist und dieses umlenkt und die zweite Umlenkfläche mit dem elektrischen Leiter in Kontakt ist und diesen umlenkt. In einer solchen Ausführungsform dient das Zugorgan der mechanischen Synchronisierung, während der elektrische Leiter bzw. das Kabel mit geringerer Spannung geführt wird und ausschließlich der elektrischen Leistungs- oder Signalübertragung dient. Durch die Kombination des elektrischen Leiters mit dem zusätzlichen, davon getrennten Zugorgan oder die Integration des elektrischen Leiters in das Zugorgan können hohe Kräfte, die zum Beispiel beim Beschleunigen oder Verzögern der Schienenelemente entstehen, von dem Zugorgan aufgenommen werden und es wird verhindert, dass der elektrische Leiter Schaden nimmt.

In einer Ausführungsform der Erfindung weist das lineare Führungssystem eine Antriebseinrichtung, beispielsweise einen Spindelantrieb mit einem Elektromotor auf, wobei die Antriebseinrichtung an dem ersten Schienenelement gelagert ist oder an einem mit dem ersten Schienenelement verbindbaren Halteelement lagerbar ist und wobei die Antriebseinrichtung derart ausgestaltet ist, dass die Antriebseinrichtung in einem Betrieb der Auszugsschiene eine lineare Verschiebebewegung des dritten Schienenelements gegenüber dem ersten Schienenelement in oder entgegen der Auszugsrichtung bewirkt.

In einer Ausführungsform der Erfindung ist das lineare Führungssystem ausgewählt aus einer Gruppe bestehend aus einer Auszugsschiene (eine solche wird oft auch als Teleskopschiene bezeichnet) und einer Linearführung. Dabei umfasst der Oberbegriff lineares Führungssystem sowohl Gleitführungen als auch Wälzkörperführungen, insbesondere Kugelführungen oder Rollenführungen.

Unter einer Linearführung im Sinne der vorliegenden Anmeldung wird ein lineares Führungssystem verstanden, bei dem eines der ersten oder zweiten Schienenelemente deutlich kürzer ist als das andere Schienenelement. Es versteht sich, dass eine Ausführungsform des linearen Führungssystems, bei der das dritte Element ein Wälzkörperkäfig ist, insbesondere zur Realisierung einer Linearführung geeignet ist, bei welcher das erste oder das zweite Schienenelement deutlich kürzer ist als das jeweils andere Schienenelement.

Im Sinne der vorliegenden Anmeldung wird unter der Auszugsrichtung die Richtung verstanden, in der das erste Schienenelement und das zweite Schienenelement relativ linear gegeneinander bewegt werden können, um von einer Einzugsposition in eine Auszugsposition zu gelangen. Entsprechend ist eine Richtung entgegen der Auszugsposition diejenige Richtung, in welcher die ersten und zweiten Schienenelemente relativ zueinander bewegt werden, um wieder in die Einzugsposition zu gelangen. Bei einer Auszugsschiene bezeichnet die Einzugsposition diejenige Position des ersten und des zweiten Schienenelements relativ zueinander, in welcher die Auszugsschiene vollständig eingeschoben ist. Die Auszugsposition bezeichnet dann diejenige Position des ersten und des zweiten Schienenelements relativ zueinander, in welcher die Auszugsführung maximal ausgezogen ist. Bei einer Linearführung bezeichnen die Einzugsposition und die Auszugsposition die beiden Endpositionen des kurzen Schienenelements gegenüber dem langen Schienenelement.

Wenn in der vorliegenden Anmeldung ausgeführt wird, dass das erfindungsgemäße lineare Führungssystem ein erstes Schienenelement und ein zweites Schienenelement aufweist, so schließt dies nicht aus, dass das lineare Führungssystem, insbesondere wenn es sich um eine Auszugsschiene handelt, weitere Schienenelemente, insbesondere insgesamt drei Schienenelemente umfasst.

In einer Ausführungsform der Erfindung weisen das erste und das zweite Schienenelement jeweils zwei Laufflächen auf, wobei auf den Laufflächen des ersten Schienenelements und auf den Laufflächen des zweiten Schienenelements in einem Wälzkörperkäfig aufgenommene Wälzkörper angeordnet sind. Diese Wälzkörper rollen auf den jeweiligen Laufflächen ab und verringern eine Reibung zwischen dem ersten Schienenelement und dem zweiten Schienenelement. Sind das erste Schienenelement und das zweite Schienenelement unmittelbar aneinandergelagert, so rollen die Wälzkörper auf jeweils einer Lauffläche des ersten Schienenelements und des zweiten Schienenelements ab. In einer Ausführungsform, bei der zwischen dem ersten Schienenelement und dem zweiten Schienenelement ein drittes Schienenelement angeordnet ist, rollen jeweils Wälzkörper auf einer Lauffläche des ersten Schienenelements und einer Lauffläche des dritten Schienenelements bzw. auf einer Lauffläche des zweiten Schienenelements und einer Lauffläche des dritten Schienenelements ab.

Unter einem Wälzkörper im Sinne der vorliegenden Anmeldung wird ein Rotationskörper verstanden, der als Element einer Führung die Reibung zwischen den verschiedenen Schienenelementen erheblich reduziert und damit eine Relativbewegung zweier Schienenelemente zueinander erleichtert. Wälzkörper sind beispielsweise Kugeln, Rollen, Tonnen, Nadeln oder Kegel. In einer Ausführungsform der vorliegenden Erfindung sind die Wälzkörper Kugeln. Es versteht sich, dass in diesem Fall der Wälzkörperkäfig ein Kugelkäfig ist. In einer Ausführungsform der Erfindung ist zumindest der Kugelkäfig aus einem Material gefertigt, das ausgewählt ist aus einer Gruppe bestehend aus Stahlblech, aluminiertem Stahlblech, Edelstahl und Kunststoff.

In einer Ausführungsform der Erfindung ist zumindest das erste Schienenelement oder das zweite Schienenelement aus einem Material gefertigt, das ausgewählt ist aus einer Gruppe bestehend aus Stahlblech, aluminiertem Stahlblech, Edelstahl und Kunststoff.

In einer Ausführungsform der Erfindung weisen zumindest das erste Schienenelement, das zweite Schienenelement oder das dritte Schienenelement einen Schienenrücken und mit dem Schienenrücken diesem verbundene Laufflächen auf, wobei die Laufflächen je nach Anordnung zueinander hin oder voneinander weg zeigen. Das Querschnittsprofil eines solchen Schienenelements ist im Wesentlichen C-förmig.

In einer solchen Ausführungsform ist der elektrische Leiter geschützt zwischen den beiden Schienenrücken zweier aneinandergelagerter Schienenelemente, d.h. entweder zwischen dem ersten und dem zweiten Schienenelement oder aber zwischen dem ersten Schienenelement und dem dritten Schienenelement oder zwischen dem zweiten Schienenelement und dem dritten Schienenelement aufgenommen.

Weitere Vorteile, Merkmale und Anwendungsmöglichkeiten der vorliegenden Erfindung werden anhand der folgenden Beschreibung von Ausführungsformen davon und der dazugehörigen Figuren deutlich. In den Figuren sind gleiche Elemente mit gleichen Bezugszeichen bezeichnet.
- Figur 1: ist eine isometrische Darstellung einer Linearführung als einer ersten Ausführungsform eines linearen Führungssystems gemäß der vorliegenden Erfindung.
- Figur 2: ist eine Querschnittsansicht durch das lineare Führungssystem aus Figur 1.
- Figur 3: ist eine Draufsicht von oben auf das lineare Führungssystem aus den Figuren 1 und 2.
- Figur 4: ist eine Seitenansicht auf den Kugelkäfig des linearen Führungssystems aus den Figuren 1 bis 3.
- Figur 5: ist eine vergrößerte Darstellung des mit Y in Figur 4 bezeichneten Bereichs des Kugelkäfigs.
- Figur 6: ist eine isometrische Darstellung einer Auszugsschiene als einer zweiten Ausführungsform eines linearen Führungssystems gemäß der vorliegenden Erfindung.
- Figur 7: ist eine isometrische Darstellung des dritten Schienenelements des linearen Führungssystems aus Figur 6.
- Figur 8: ist eine seitliche Schnittansicht in Längsrichtung durch das lineare Führungssystem aus Figur 6.
- Figur 9: ist eine Draufsicht von oben auf das lineare Führungssystem aus den Figuren 6 bis 8.
- Figur 10: ist eine vergrößerte Darstellung des mit Z bezeichneten Bereichs aus Figur 8.
- Figur 11: ist eine Schnittansicht des linearen Führungssystems aus den Figuren 6 bis 11 entlang der Linie D-D aus Figur 9.
- Figur 12: ist eine weggebrochene vergrößerte Ansicht des mit X bezeichneten Bereichs aus Figur 11.
- Figur 13: ist eine isometrische Ansicht des Umlenkelements des linearen Führungssystems aus den Figuren 6 bis 12.

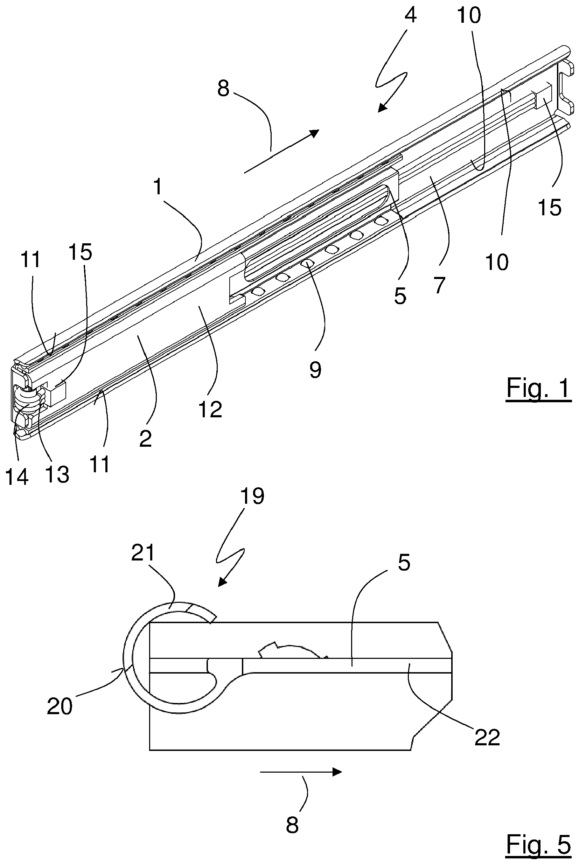

Die Ausführungsform des linearen Führungssystems gemäß den Figuren 1 bis 5 wird von einer Linearführung 4 gebildet. Die Linearführung 4 umfasst ein erstes Schienenelement 1, ein zweites Schienenelement 2 und ein drittes Element. Das dritte Element ist im Fall der gezeigten Linearführung 4 von einem Kugelkäfig 5 gebildet. Charakteristisch für eine Linearführung ist, dass das erste Schienenelement 1 deutlich länger ist als das zweite Schienenelement 2. Der maximale Verfahrweg des zweiten Schienenelements 2 gegenüber dem ersten Schienenelement 1 ist auf die Länge des ersten Schienenelements 1 abzüglich der Länge des zweiten Schienenelements 2 beschränkt. Der Kugelkäfig 5 hat etwa die doppelte Länge wie das zweite Schienenelement 2 und in etwa zwei Drittel der Länge des ersten Schienenelements.

Das zweite Schienenelement 2 ist in und entgegen einer Auszugsrichtung 8 gegenüber dem ersten Schienenelement 1 verschiebbar an diesem gelagert. Dazu weist die Linearführung 4 eine Kugellagerung auf, welche den Kugelkäfig 5 und eine Mehrzahl von daran aufgenommenen Wälzkörpern in Form von Kugeln 9 umfasst. Die Kugeln 9 rollen auf Laufflächen 10 des ersten Schienenelements 1 und Laufflächen 11 des zweiten Schienenelements 2 ab bzw. wälzen zwischen den Laufflächen 10, 11 des ersten und zweiten Schienenelements 1, 2. Die Laufflächen 10 des ersten Schienenelements 1 sind durch einen Schienenrücken 7 miteinander verbunden. Die Laufflächen 11 des zweiten Schienenelements 2 sind durch einen Schienenrücken 12 miteinander verbunden.

Die Idee der erfindungsgemäßen Linearführung 4 ist es nun, neben einer Linearbewegung eines bewegten, mit dem zweiten Schienenelement 2 verbundenen Elements gegenüber einem mit dem ersten Schienenelement verbundenen stationären Element auch eine Spannungsversorgung oder eine Signalübertragung von dem stationären ersten Schienenelement

1 zu dem zweiten Schienenelement 2 zu ermöglichen. Zu diesem Zweck weist die Linearführung 4 eine Mehrzahl von elektrischen Leitern 13 in einem Flachbandkabel 14 auf. Das Kabel 14 und mit ihm die elektrischen Leiter 13 sind an ihren Enden mit jeweils einem Stecker 15 als elektrischem Verbindungselement im Sinne der vorliegenden Anmeldung verbunden. Die Stecker 15 ermöglicht eine einfache elektrische Kontaktierung der elektrischen Leiter 13 sowohl an dem ersten Schienenelement 1 als auch an dem zweiten Schienenelement 2. So kann beispielsweise der Stecker 15 an dem ersten Schienenelement mit einer Spannungsversorgung verbunden werden und der Stecker 15 an dem zweiten Schienenelement mit einem Verbraucher. Genauso gut ist aber auch die Übertragung von Information bzw. Daten über die elektrischen Leiter 13 des Flachbandkabels 14 zwischen den Steckern 15 möglich.

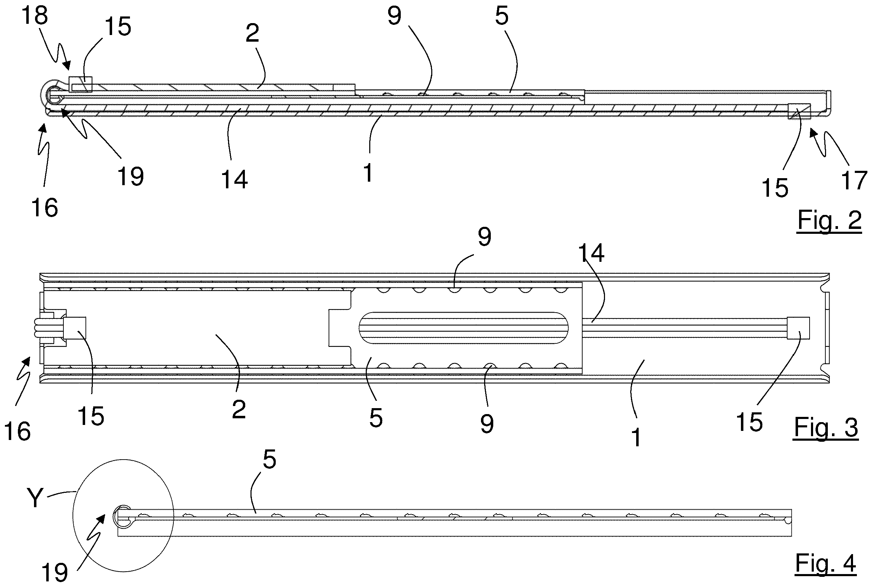

Die Führung des Kabels 14 und damit die Funktion des erfindungsgemäßen linearen Führungssystems ist nun am besten anhand der Darstellungen der Figuren 2 bis 5 erkennbar. In der Schnittansicht der Linearführung 4 aus Figur 1 ist der gesamte Verlauf des Kabels 14 zwischen dem Stecker 15 an dem ersten Schienenelement 1 und dem Stecker 15 an dem zweiten Schienenelement 2 zu erkennen. Das Flachbandkabel verläuft im Wesentlichen parallel zu den Schienenrücken 7, 12 der beiden Schienenelemente 1, 2.

Das Flachbandkabel 14 ist an einem Umlenkort 16 an dem Kugelkäfig 5 umgelenkt. Ferner ist das Flachbandkabel 14 mit Hilfe der Stecker 15 an einem ersten Festlegungsort 17 an dem ersten Schienenelement 1 und mit dem Stecker 15 an einem zweiten Festlegungsort 18 an dem zweiten Schienenelement 2 festgelegt. Die Länge des Flachbandkabels ist so bemessen, dass es die Wegstrecke von dem ersten Stecker 15 an dem ersten Schienenelement 1 und dem Umlenkort 16 an dem Kugelkäfig 5 und von dem Umlenkort 16 zu dem zweiten Stecker 15 an dem zweiten Schienenelement 2 überbrückt. Die Summe aus der Teilweglänge von dem ersten Stecker 15 an dem ersten Schienenelement 1 bis zu dem Umlenkort 16 und der zweiten Teilweglänge von dem Umlenkort 16 zu dem zweiten Stecker 15 an dem zweiten Schienenelement 2 ist die Gesamtweglänge des elektrischen Leiters 13 oder des Kabels 14 im Sinne der vorliegenden Anmeldung. Diese Gesamtweglänge ist über alle Betriebszustände, d.h. Verfahrpositionen des zweiten Schienenelements 2 gegenüber dem ersten Schienenelement 1, konstant.

Wird das zweite Schienenelement 2, zum Beispiel aus der in den Figuren 1 bis 3 gezeigten Endlage nach rechts, verschoben, so ändern sich die erste Teilweglänge und die zweite Teilweglänge in gleichem Maß, jedoch mit unterschiedlichem Vorzeichen. Bezogen auf das Beispiel der Figuren 1 bis 3 bedeutet dies, dass die erste Teilweglänge verkürzt und die zweite Teilweglänge verlängert wird. Möglich ist dies, da bei einer Bewegung des zweiten Schienenelements 2 relativ zum ersten Schienenelement 1 um eine erste Verschiebestrecke der Kugelkäfig 5 gegenüber dem ersten Schienenelement 1 um eine zweite Verschiebestrecke die gleich die Hälfte der ersten Verschiebestrecke ist, bewegt wird.

Für die Umlenkung weist der Kugelkäfig 5 an dem Umlenkort 16 ein Umlenkelement 19 auf. Das Umlenkelement 19 ist gut in den Querschnittsansichten aus den Figuren 2 und 4 zu erkennen und darüber hinaus vergrößert in derweggebrochenen Ansicht aus Figur 5 dargestellt. In der dargestellten Ausführungsform umfasst das Umlenkelement 19 eine konvex gekrümmte Gleitfläche 20. Auf dieser Gleitfläche 20 gleitet das Flachbandkabel 14 während einer Verschiebebewegung des zweiten Schienenelements 2 und damit des Kugelkäfigs 5 gegenüber dem ersten Schienenelement 1.

Das Umlenkelement 19 besteht aus einer gekrümmt verlaufenden Lasche 21, welche die konvex gekrümmte Gleitfläche 20 trägt. Durch diese Ausführung des Umlenkelements 19 bildet das Umlenkelement 19 eine Feder, d.h. die Gleitfläche 20 kann auf die Auszugsrichtung 8 bezogen unterschiedliche Positionen relativ zu dem Rest des Kugelkäfigs 5, welcher im Sinne der vorliegenden Anmeldung als Grundkörper 22 des Kugelkäfigs 5 bezeichnet wird, angeordnet werden. Aufgrund der Ausgestaltung kann die Gleitfläche 20 nicht nur eine erste und eine zweite Spannposition bezogen auf den Grundkörper 22 einnehmen, sondern ist kontinuierlich innerhalb ihrer geometrischen Grenzen entgegen der von der Lasche 21 bereitgestellten Federkraft beweglich. Auf diese Weise stellt das Umlenkelement 19 einen Kabelspanner für das Kabel 14 bereit und hält das Kabel 14 über den gesamten Verfahrweg des zweiten Schienenelements 2 gegenüber dem ersten Schienenelement 1 straff gespannt. Dies dient dem Ausgleich von Toleranzen und verhindert wirksam, dass das Kabel 14 in irgendeiner Weise mit dem Verfahrweg des zweiten Schienenelements 2 bzw. des Kugelkäfigs 5 gegenüber dem ersten Schienenelement 1 kollidiert.

In der dargestellten Ausführungsform ist der Kugelkäfig 5 durch Spritzgießen aus Kunststoff hergestellt. Auf diese Weise ist auch die Realisierung komplexer Formen des Umlenkelements 19 möglich. Alternativ dazu kann der Kugelkäfig aus Stahlblech durch Stanzen und Biegen gefertigt sein. Die Lasche 5 mit der Gleitfläche 19 wird dann aus dem Blech herausgestanzt und umgebogenen, so dass sie die gezeigte Form erhält.

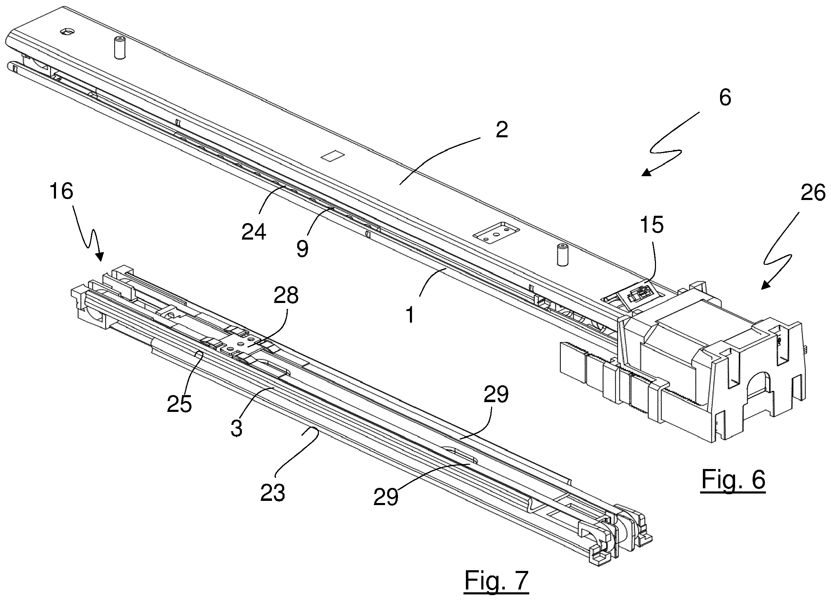

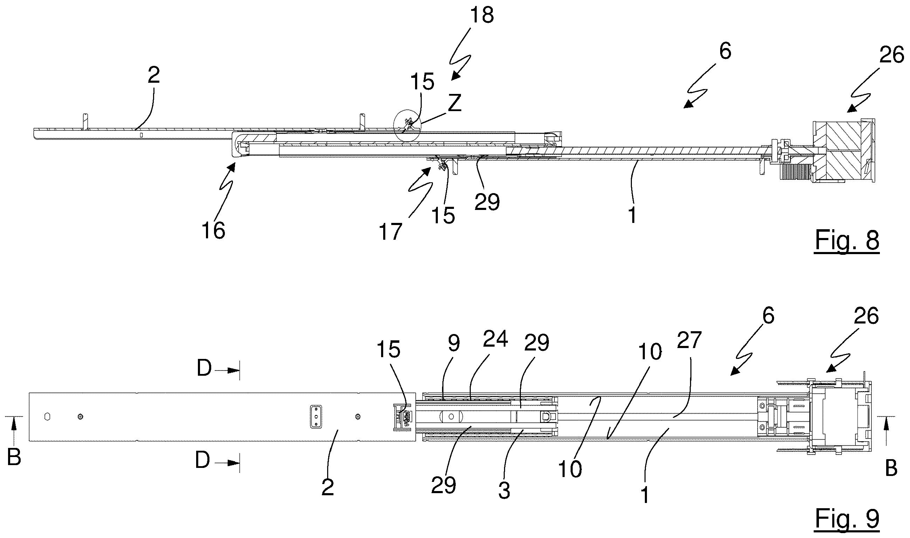

Die Figuren 6 bis 13 zeigen eine alternative Ausführungsform des linearen Führungssystems. In dieser Ausführungsform ist das lineare Führungssystem eine Auszugsschiene 6. Die Auszugsschiene 6 bildet einen Vollauszug, d.h. das zweite Schienenelement 2 kann über seine gesamte Länge gegenüber dem ersten Schienenelement 1 und aus diesem heraus verfahren werden. Dazu weist die Auszugsführung 6 ein drittes Schienenelement 3 auf. Dieses dritte Schienenelement 3 bildet in der Ausführungsform der Figuren 6 bis 13 das dritte Element im Sinne der vorliegenden Anmeldung.

Das dritte Schienenelement 3 dient in dieser Ausführungsform auch der Umlenkung des Flachbandkabels 14. Das dritte Schienenelement 3 ist über ein erstes Paar von Laufflächen 23 mit Hilfe von in einem Kugelkäfig 24 angeordneten Lagerkugeln 9 an dem ersten Schienenelement 1 gelagert. Die Lagerkugeln rollen andererseits auf den Laufflächen 10 des ersten Schienenelements 1 ab. Das zweite Schienenelement 2 wiederum ist über eine entsprechende Kugellagerung mit Lagerkugeln 9 und einem Wälzkörperkäfig verschieblich an dem dritten Schienenelement 3 gelagert. Zu diesem Zweck weist das dritte Schienenelement 3 ein zweites Paar von Laufflächen 25 auf.

Aufgrund der Kugellagerung des dritten Schienenelements 3 am ersten Schienenelement 1 und des zweiten Schienenelements 2 am dritten Schienenelement 3 ist bei einem ersten Verfahrweg des zweiten Schienenelements gegenüber dem ersten Schienenelement 1 der zweite Verfahrweg des dritten Schienenelements 3 gegenüber dem ersten Schienenelement 1 in etwa gleich der Hälfte des ersten Verfahrwegs. Daher hält auch eine Umlenkung des Flachbandkabels 14 bei der Ausführungsform aus den Figuren 6 bis 13 die Gesamtweglänge des Flachbandkabels 14 von dem ersten Stecker 15 an dem ersten Schienenelement 1 (erster Festlegungsort 17 des Kabels 14) zu dem Umlenkungsort 16 an dem dritten Schienenelement 3 und von dem Umlenkungsort 16 zu dem Stecker 15 an dem zweiten Schienenelement 2 (zweiter Festlegungsort 18 des Kabels 14) im Wesentlichen konstant. Für die Umlenkung des Flachbandkabels lässt sich somit bei dieser Ausführungsform das gleiche Konzept realisieren, wie bei der Umlenkung am Kugelkäfig 5 gemäß der ersten Ausführungsform aus den Figuren 1 bis 5.

Bei der Auszugsschiene 6 aus den Figuren 6 bis 13 handelt es sich um eine motorisch angetriebene Schiene. Daher weist diese einen an das erste Schienenelement 1 angeflanschten Elektromotor 26 auf. Dieser Elektromotor 26 treibt einen Spindeltrieb mit einer Gewindespindel 27, welche mit einer Gewindemutter, die an dem dritten Schienenelement 3 festgelegt ist, an. Eine Drehung der Gewindespindel 27 bewirkt ein Verfahren des dritten Schienenelements 3 gegenüber dem ersten Schienenelement 1. Gleichzeitig ist eine Auszugsbewegung oder Einzugsbewegung des zweiten Schienenelements 2 gegenüber dem dritten Schienenelement 3 mithilfe eines Paars von Zugorganen 29 synchronisiert. Jedes dieser Zugorgane 29 ist über eine erste Montageplatte 28 an dem zweiten Schienenelement 2 einerseits und über eine zweite Montageplatte 33 an dem ersten Schienenelement 1 andererseits festgelegt. Die Zugorgane 29 sind an beiden Enden des dritten Schienenelements 3 umgelenkt. Auf diese Weise wird eine Relativbewegung des dritten Schienenelements 1 gegenüber dem ersten Schienenelement 1 in eine synchrone Relativbewegung des zweiten Schienenelements 2 gegenüber dem dritten Schienenelement 3 umgesetzt.

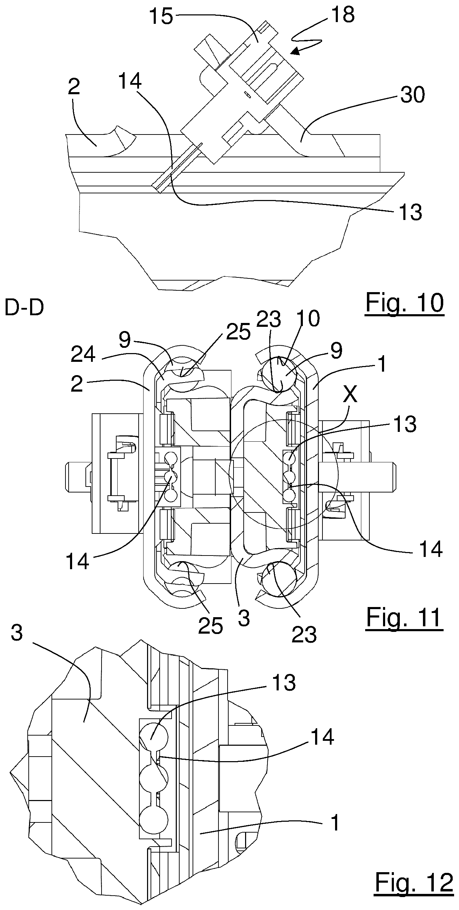

Figur 10 zeigt den Stecker 15 an dem zweiten Schienenelement 2. Dieser Stecker 15 dient gleichzeitig der Festlegung des Flachbandkabels 14 und damit der elektrischen Leiter 13 in dem Flachbandkabel 14 an dem zweiten Festlegungsort 18 an dem zweiten Schienenelement 2. Zu diesem Zweck weist der Stecker 15 eine Durchbrechung auf, durch die eine Lasche 30, die aus dem Schienenrücken 7 des zweiten Schienenelements 2 herausgestanzt und von dem Schienenrücken 7 abgebogen ist.

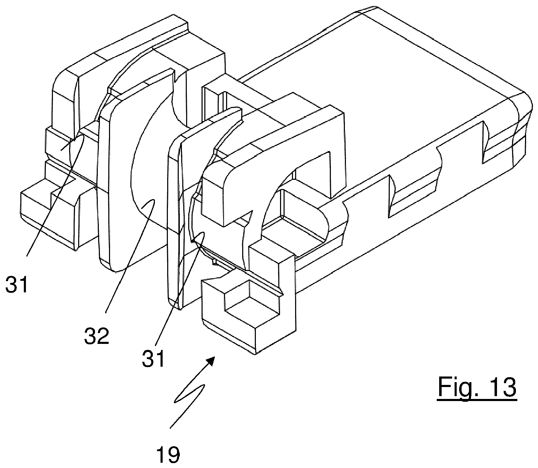

Figur 13 zeigt das Umlenkelement 19 des dritten Schienenelements 3. Dieses dient sowohl der Umlenkung der beiden Zugorgane 29 als auch der Umlenkung des Flachbandkabels 14. Zu diesem Zweck weist das Umlenkelement 19 zwei erste Umlenkflächen 31 auf, welche der Umlenkung der Zugorgane 29 dienen. Diese Umlenkflächen 31 sind so ausgestaltet, dass eine Gleitreibung der Zugorgane 29 gegenüber den Umlenkflächen 31 möglichst minimiert ist. Zu diesem Zweck sind die Umlenkflächen 31konvex gekrümmt und in Umfangsrichtung unterbrochen, sodass die Auflagefläche verringert ist. Zwischen den beiden ersten Umlenkflächen 31 ist eine zweite Umlenkfläche 32 vorgesehen, welche der Umlenkung des Flachbandkabels 14 dient. Die Umlenkflächen 31, 32 sind im Sinne der vorliegenden Anmeldung Gleitflächen, da sowohl die Zugorgane 29 als auch das Flachbandkabel 14 bei einer Relativbewegung der Schienenelemente 1, 2, 3 gegeneinander eine Gleitbewegung gegenüber den Umlenkflächen 31, 32 ausführen. Die Umlenkflächen 31, 32 könnten jedoch auch als Flächen einer oder mehrerer gegenüber dem Umlenkelement 19 verschwenkbarer Rollen ausgeführt sein.

In der dargestellten Ausführungsform bewirken die Zugorgane 29 eine Entlastung des Flachbandkabels 14, da die Zugorgane 29 die Synchronisation der Bewegungen der Schienenelemente 1, 2, 3 relativ zueinander bewirken, sodass die Führung des Flachbandkabels 14 weitgehend kräftefrei erfolgen kann. In einer alternativen Ausführungsform kann es aber stattdessen angezeigt sein, auch die Synchronisation durch das Flachbandkabel 14 zu bewirken. Dann können die zusätzlichen Zugorgane 29 entfallen.

Für Zwecke der ursprünglichen Offenbarung wird darauf hingewiesen, dass sämtliche Merkmale, wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

Während die Erfindung im Detail in den Zeichnungen und der vorangehenden Beschreibung dargestellt und beschrieben wurde, erfolgt diese Darstellung und Beschreibung lediglich beispielhaft und ist nicht als Beschränkung des Schutzbereichs gedacht, so wie er durch die Ansprüche definiert wird. Die Erfindung ist nicht auf die offenbarten Ausführungsformen beschränkt.

Abwandlungen der offenbarten Ausführungsformen sind für den Fachmann aus den Zeichnungen, der Beschreibung und den beigefügten Ansprüchen offensichtlich. In den Ansprüchen schließt das Wort "aufweisen" nicht andere Elemente oder Schritte aus, und der unbestimmte Artikel "eine" oder "ein" schließt eine Mehrzahl nicht aus. Die bloße Tatsache, dass bestimmte Merkmale in unterschiedlichen Ansprüchen beansprucht sind, schließt ihre Kombination nicht aus. Bezugszeichen in den Ansprüchen sind nicht als Beschränkung des Schutzbereichs gedacht.

### Bezugszeichenliste

- 1: erstes Schienenelement
- 2: zweites Schienenelement
- 3: drittes Schienenelement
- 4: Linearführung
- 5: Kugelkäfig
- 6: Auszugsschiene
- 7: Schienenrücken
- 8: Auszugsrichtung
- 9: Kugeln
- 10: Laufflächen des ersten Schienenelements
- 11: Laufflächen des zweiten Schienenelements
- 12: Schienenrücken
- 13: elektrische Leiter
- 14: Kabel
- 15: Stecker
- 16: Umlenkort
- 17: erster Festlegungsort
- 18: zweiter Festlegungsort
- 19: Umlenkelement
- 20: Gleitfläche
- 21: Lasche
- 22: Grundkörper
- 23: erstes Paar von Laufflächen
- 24: Kugelkäfig
- 25: zweites Paar von Laufflächen
- 26: Elektromotor
- 27: Gewindespindel
- 28: erste Montageplatte
- 29: Zugorgan
- 30: Lasche
- 31: Umlenkfläche
- 32: Umlenkfläche
- 33: zweite Montageplatte

## Patentansprüche

1. Lineares Führungssystem (4, 6) mit
einem ersten Schienenelement (1),
einem zweiten Schienenelement (2) und
einem dritten Element (3, 5),
wobei das erste Schienenelement (1) und das zweite Schienenelement (2) derart gelagert sind, dass das erste Schienenelement (1) und das zweite Schienenelement (2) in und entgegen einer Auszugsrichtung (8) linear gegeneinander verschiebbar sind,
wobei das dritte Element (3, 5) und das erste Schienenelement (1) sowie das dritte Element (3, 5) und das zweite Schienenelement (2) aneinander gelagert sind, so dass das dritte Element (3, 5) und das erste Schienenelement (1) sowie das dritte Element (3, 5) und das zweite Schienenelement (2) in und entgegen der Auszugsrichtung (8) linear gegeneinander verschiebbar sind,
**dadurch gekennzeichnet, dass**
das lineare Führungssystem (4, 6) einen elektrischen Leiter (13) aufweist, wobei der elektrische Leiter (13) an dem ersten Schienenelement (1) an einem ersten Festlegungsort (17) und an dem zweiten Schienenelement (2) an einem ersten Festlegungsort (18) festgelegt ist,
wobei der elektrische Leiter (13) gegenüber zumindest dem dritten Element (3, 5) elektrisch isoliert ist und
wobei der elektrische Leiter (13) an einem Umlenkort (16) an dem dritten Element (3) umgelenkt ist.

2. Lineares Führungssystem (4, 6) nach dem vorhergehenden Anspruch, wobei der elektrische Leiter (13) an dem Umlenkort (16) derart umgelenkt ist, dass unabhängig von einer Auszugsposition des ersten Schienenelements (1) gegenüber dem zweiten Schienenelement (2) eine Gesamtweglänge des elektrischen Leiters (13), die gebildet ist als Summe aus einer erste Teilweglänge zwischen dem ersten Festlegungsort (17) und dem Umlenkort (16) und einer zweiten Teilweglänge zwischen dem ersten Festlegungsort (18) und dem Umlenkort (16), im Wesentlichen konstant ist.

3. Lineares Führungssystem (4, 6) nach einem der vorhergehenden Ansprüche, wobei das dritte Element ein Wälzkörperkäfig (5) ist, der zwischen dem ersten Schienenelement (1) und dem zweiten Schienenelement (2) angeordnet ist, wobei an dem Wälzkörperkäfig (5) eine Mehrzahl von Wälzkörpern (9) aufgenommen ist, und wobei jeder aus der Mehrzahl von Wälzkörpern (9) auf einer Lauffläche (10) des ersten Schienenelements (1) und auf einer Lauffläche (11) des zweiten Schienenelements (2) abrollt.

4. Lineares Führungssystem (4, 6) nach einem der Ansprüche 1 oder 2, wobei das lineare Führungssystem eine Auszugsschiene (6) ist und das dritte Element (3, 5) ein drittes Schienenelement (3) ist.

5. Lineares Führungssystem (4, 6) nach einem der vorhergehenden Ansprüche, wobei das dritte Element (3, 5) an dem Umlenkort (16) ein Umlenkelement (19) aufweist, wobei der elektrische Leiter (13) mit dem Umlenkelement (19) in Kontakt ist und von dem Umlenkelement (19) umgelenkt wird und wobei das Umlenkelement (19) ausgewählt ist aus einer Gruppe, die eine konvex gekrümmte Gleitfläche (20), eine Mehrzahl von Gleitflächenabschnitten mit zumindest einer Ausnehmung zwischen zwei Gleitflächenabschnitten und eine schwenkbare Umlenkrolle, oder eine Kombination davon umfasst.

6. Lineares Führungssystem (4, 6) nach einem der vorhergehenden Ansprüche, wobei das dritte Element (3, 5) an dem Umlenkort (16) ein Umlenkelement (19) aufweist, wobei der elektrische Leiter (13) mit dem Umlenkelement (19) in Kontakt ist und von dem Umlenkelement (19) umgelenkt wird, und wobei das Umlenkelement (19) gegenüber einem Grundkörper (22) des dritten Elements (3, 5) zumindest an einer ersten Spannposition und einer zweiten Spannposition in der Auszugsrichtung (8) positionierbar ist.

7. Lineares Führungssystem (4, 6) nach dem vorhergehenden Anspruch, wobei das Umlenkelement in oder entgegen der Auszugsrichtung (8) federnd vorgespannt ist, so dass das Umlenkelement (19) den elektrischen Leiter (13) spannt.

8. Lineares Führungssystem (4, 6) nach einem der vorhergehenden Ansprüche, wobei an dem dritten Element (3, 5) ein Kabelspanner vorgesehen ist, wobei der Kabelspanner derart ausgestaltet und angeordnet ist, dass er den elektrischen Leiter (13) in einer Richtung senkrecht zur Auszugsrichtung (8) spannt.

9. Lineares Führungssystem (4, 6) nach einem der vorhergehenden Ansprüche, wobei der elektrische Leiter (13) gegenüber dem ersten Schienenelement (1) und dem zweiten Schienenelement (2) elektrisch isoliert ist.

10. Lineares Führungssystem (4, 6) nach einem der vorhergehenden Ansprüche, wobei der elektrische Leiter (13) Bestandteil eines Kabels, vorzugsweise eines Flachbandkabels (14), ist.

11. Lineares Führungssystem (4, 6) nach einem der vorhergehenden Ansprüche, wobei das lineare Führungssystem (4, 6) ein elektrisches Verbindungselement (15) aufweist, wobei ein erstes Ende des elektrischen Leiters (13) mit dem Verbindungselement (15) konfektioniert ist und wobei das Verbindungselement (15) vorzugsweise an dem ersten oder dem zweiten Schienenelement (2) befestigt ist.

12. Lineares Führungssystem (4, 6) nach dem vorhergehenden Anspruch, wobei das Verbindungselement (15) derart ausgestaltet ist, dass es den elektrischen Leiter (13) an dem ersten Schienenelement (1) oder dem zweiten Schienenelement (2) festlegt.

13. Lineares Führungssystem (6) nach einem der vorhergehenden Ansprüche,
wobei das lineare Führungssystem eine Auszugsschiene (6) ist,
wobei das dritte Element (3, 5) ein drittes Schienenelement (3) ist,
wobei das dritte Schienenelement (3) an dem Umlenkort (16) ein Umlenkelement (19) aufweist,
wobei der elektrische Leiter (13) mit dem Umlenkelement (19) in Kontakt ist und von dem Umlenkelement (19) umgelenkt wird,
wobei die Auszugsschiene (6) ein Zugorgan (29) aufweist,
wobei das Zugorgan (29) an dem ersten Schienenelement (1) und an dem dritten Schienenelement (3) festgelegt ist und
wobei das Zugorgan (29) an dem Umlenkelement (19) in einer Richtung parallel zu der Auszugsrichtung (8) derart geführt ist, dass eine Verschiebebewegung des dritten Schienenelements (3) gegenüber dem ersten Schienenelement (1) zu einer Verschiebbewegung des zweiten Schienenelements (2) gegenüber dem dritten Schienenelement (3) führt.

14. Lineares Führungssystem (4, 6) nach dem vorhergehenden Anspruch, wobei das Umlenkelement (19) eine erste Umlenkfläche (31) und eine zweite Umlenkfläche (32) aufweist, wobei die erste Umlenkfläche (31) mit dem Zugorgan (29) in Kontakt ist und dieses umlenkt und die zweite Umlenkfläche (32) mit dem elektrischen Leiter (13) in Kontakt ist und diesen umlenkt.

15. Lineares Führungssystem (6) nach Anspruch 13, wobei der elektrische Leiter (13) das Zugorgan (29) bildet oder der elektrische Leiter (13) in das Zugorgan integriert ist, vorzugsweise in das Zugorgan (29) eingewoben ist.
